# EUROPÄISCHE PATENTANMELDUNG

(11) **EP 2 527 856 A1**
(43) Veröffentlichungstag der Anmeldung: **28.11.2012**
(21) Anmeldenummer: 12165834.8
(22) Anmeldetag: 27.04.2012
(51) Int. Cl.: G01R 31/36

(54) **Vorrichtung und Verfahren zur Überwachung von Betriebsdaten einer Batterieanlage**

(30) Priorität: 21.05.2011 DE 102011102211
(71) Anmelder: Otto Diez Elektromaschinenbau, 73265 Dettingen/Teck (DE)
(72) Erfinder: Rarbach, Johannes, 59889 Eslohe (DE)
(74) Vertreter: Ruckh, Rainer Gerhard

(57) **Zusammenfassung**

Die erfindungsgemäße Vorrichtung dient zur Überwachung von Betriebsdaten einer Batterieanlage. Diese besteht aus einer Anordnung von miteinander verschalteten Batteriezellen (1). Zumindest ein Teil der Batteriezellen (1) weist eine Aufnahme auf, auf welche ein elektrischer Anschluss der Batteriezelle (1) geführt ist. An den Aufnahmen ist ein Testmodul (7) anbringbar. Durch das Anbringen wird das Testmodul (7) elektrisch an die Batteriezelle (1) angeschlossen, ohne den Betrieb der Batteriezelle (1) zu unterbrechen. Mit dem Testmodul (7) sind Betriebsdaten erfassbar. Weiterhin betrifft die Erfindung ein Verfahren zur Überwachung von Betriebsdaten einer Batterieanlage.

## Beschreibung

Die Erfindung betrifft eine Vorrichtung und ein Verfahren zur Überwachung von Betriebsdaten einer Batterieanlage.

Batterieanlagen der in Rede stehenden Art umfassen typischerweise eine große Anzahl einzelner Batteriezellen, die über eine Reihenschaltung miteinander verbunden sind. Eine ausgebildete Batterieanlage weist eine sehr große Batteriekapazität auf, so dass diese bei einem Ausfall des öffentlichen Stromnetzes eine Notstromversorgung für große und gegebenenfalls auch sicherheitskritische Anlagen wie zum Beispiel Kernkraftwerke, Krankenhäuser, Großrechneranlagen in Banken, Versicherungen bilden kann.

Damit die Batterieanlage diese Sicherungsfunktion im Notfall übernehmen kann, ist dafür zu sorgen, dass die Batterieanlage selbst in einem Notfall betriebsbereit ist. Hierzu ist es erforderlich, die einzelnen Batteriezellen der Batterieanlage regelmäßig auf ihre Funktion zu prüfen und bei Bedarf zu warten.

Eine hierzu geeignete Testvorrichtung ist aus der DE 198 22 571 A1 bekannt. Dort ist eine Testanordnung beschrieben, die einzelne Überwachungsvorrichtungen aufweist, die an die Pole der einzelnen Batteriezellen angeschlossen werden. Die Überwachungsvorrichtungen sind an einen gemeinsamen Datenbus angeschlossen, wodurch die Überwachungsvorrichtungen einzeln abfragbar sind.

Mit der so ausgebildeten Testvorrichtung kann zwar der Funktionszustand der Batteriezellen einer Batterieanlage zuverlässig ermittelt werden. Nachteilig hierbei ist jedoch, dass zur Installation der einzelnen Überwachungsvorrichtungen der Betrieb der Batteriezelle unterbrochen werden muss, da die Leitungen der Reihenschaltung der Batteriezelle von den Polen der Batteriezelle abklemmt werden müssen um dazu die einzelnen Überwachungsvorrichtungen anzuschließen, weil ansonsten die Gefahr einer Ausbildung von Lichtbögen bei Anschluss der Testvorrichtungen bestünde. Damit aber ist die Batterieanlage für die Dauer der Installation und Funktionsprüfung, die bis zu ein oder mehrere Tage betragen kann, außer Betrieb. Bei Großanlagen bedeutet dies einen erheblichen finanziellen Verlust für den Betreiber.

Der Erfindung liegt die Aufgabe zugrunde, eine Vorrichtung und ein Verfahren bereitzustellen, um möglichst zuverlässig und mit geringen Ausfallzeiten eine Batterieanlage prüfen zu können.

Zur Lösung dieser Aufgabe sind die Merkmale der unabhängigen Ansprüche vorgesehen. Vorteilhafte Ausführungsformen und zweckmäßige Weiterbildungen der Erfindung sind in den Unteransprüchen beschrieben.

Die erfindungsgemäße Vorrichtung dient zur Überwachung von Betriebsdaten einer Batterieanlage. Diese besteht aus einer Anordnung von miteinander verschalteten Batteriezellen. Zumindest ein Teil der Batteriezellen weist eine Aufnahme auf, auf welche ein elektrischer Anschluss der Batteriezelle geführt ist. An den Aufnahmen ist ein Testmodul anbringbar. Durch das Anbringen wird das Testmodul elektrisch an die Batteriezelle angeschlossen, ohne den Betrieb der Batteriezelle zu unterbrechen. Mit dem Testmodul sind Betriebsdaten erfassbar.

Ein wesentlicher Vorteil der erfindungsgemäßen Vorrichtung besteht darin, dass Batteriezellen, vorzugsweise alle Batteriezellen der Batterieanlage, Aufnahmen aufweisen, auf welche ein elektrischer Anschluss geführt ist, der zusätzlich zu den Polen der Batteriezelle eine weitere elektrische Anschlussmöglichkeit bildet. Während die Pole der Batteriezelle elektrische Anschlüsse für Leitungen bilden, mit welchen die Batteriezellen verschaltet werden, vorzugsweise in einer Reihenschaltung, können die elektrischen Anschlüsse der Aufnahmen unabhängig hiervon zum Anschluss der einzelnen Testmodule dienen. Damit können die Testmodule durch ein Anbringen der Aufnahmen elektrisch kontaktiert werden, ohne dass die Anschlüsse der Leitungen an den Polen abgenommen werden müssen, das heißt der Anschluss der Testmodule kann erfolgen, ohne dass hierfür der Betrieb der Batteriezelle unterbrochen werden muss. Damit aber werden kostenintensive Stillstände der Batterieanlage bei deren Funktionsprüfung vermieden.

Allgemein ist die Aufnahme an das Testmodul so angepasst, dass mit Anbringen des Testmoduls dieses reversibel lösbar an der Aufnahme fixiert wird.

Gemäß einer besonders vorteilhaften Ausführungsform der Erfindung ist die Aufnahme in Form eines Schlitzes ausgebildet.

Dann ist vorteilhaft, dass das Testmodul in die Aufnahme einsteckbar oder einrastbar ist, wobei hierzu zweckmäßig die Kontur des Testmoduls an die Form des Schlitzes angepasst ist. Durch Ausbildung der Steck- oder Rastverbindung ist das Testmodul mit der Batteriezelle elektrisch kontaktiert.

Dies stellt eine besonders einfache und schnell herstellbare Ausführungsform der Kontaktierung der Testmodule dar.

Besonders vorteilhaft weist jede Batteriezelle eine Aufnahme auf, wobei die Aufnahmen identisch ausgebildet sind.

Damit können die Testmodule austauschbar an beliebigen Batteriezellen angebracht werden. Weiterhin ist vorteilhaft, dass nur ein Typ vom Testmodul zur Durchführung der Überwachung benötigt wird.

Generell ist es auch möglich, dass die Aufnahme und ein Testmodul integraler Bestandteil einer Batteriezelle sind, das heißt diese Komponenten sind fest in der Batteriezelle eingebaut.

Das erfindungsgemäße Verfahren dient zur Überwachung von Betriebsdaten einer Batterieanlage. Diese besteht aus einer Anordnung von miteinander verschalteten Batteriezellen. An einen Teil der Batteriezellen wird jeweils ein Testmodul angeschlossen, um mit dem Testmodul Betriebsdaten der Batteriezelle zu erfassen. Die von den Testmodulen erfassten Betriebsdaten werden an eine vom Betreiber der Batterieanlage unabhängige zentrale Erfassungsstelle gesendet, wo eine Bewertung der Betriesdaten erfolgt.

Vorteilhaft wird die Erfassungsstelle vom Hersteller der Batterieanlage betrieben.

Mit dem erfindungsgemäßen Verfahren wird eine zentrale Auswertung der mit den einzelnen Testmodulen erfassten Betriebsdaten ermöglicht, wobei wesentlich ist, dass die Auswertung räumlich und zeitlich unabhängig von der Erfassung der Betriebsdaten mit den Testmodulen erfolgt.

Ein wesentlicher Vorteil des erfindungsgemäßen Verfahrens besteht darin, dass der Hersteller der Batterieanlage die Auswertung der Betriebsdaten übernehmen kann und damit anstelle des Betreibers der Batterieanlage die Entscheidung treffen kann, ob zu Zwecken der Wartung oder aus Sicherheitsgründen die Batterieanlage stillgesetzt werden muss oder nicht. Dies ist deshalb vorteilhaft, da der Hersteller die notwendige Fachkompetenz hat, die von den Testmodulen erfassten Betriebsdaten richtig einzuschätzen um so eine fundierte Risikobewertung vornehmen zu können, ob eine Stillsetzung der Batterieanlage notwendig ist oder nicht. Das Ergebnis der Bewertung wird dann an den Betreiber der Batterieanlage gesendet, so dass er entsprechende Maßnahmen treffen kann.

Die Erfindung wird im Folgenden anhand der Zeichnungen erläutert. Es zeigen:
- Figur 1:: Einzeldarstellung einer Batteriezelle als Bestandteil einer Batterieanlage.
- Figur 2:: Einzeldarstellung eines Testmoduls für die Batteriezelle gemäß Figur 1.
- Figur 3:: Darstellung des in einer Aufnahme der Batteriezelle integrierten Testmoduls.

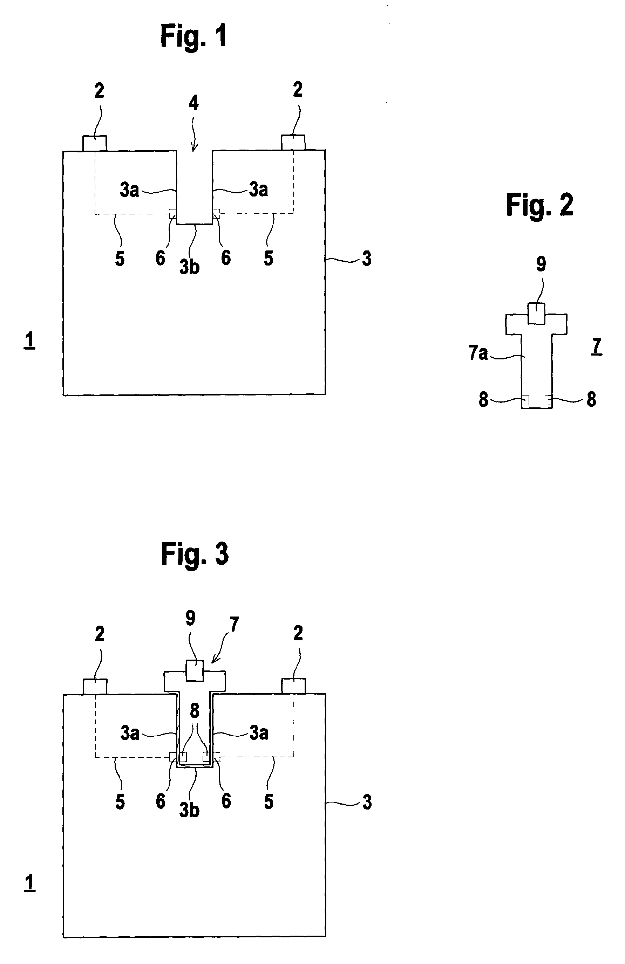

Figur 1 zeigt schematisch in einer Einzeldarstellung eine Batteriezelle 1, die eine Komponente einer Batterieanlage bildet. Die Batteriezelle 1 weist in bekannter Weise zwei Pole 2 auf, die an der Oberseite des Gehäuses 3 der Batteriezelle 1 aufsitzen. Zur Ausbildung einer Batterieanlage werden die Pole 2 der einzelnen Batteriezellen 1 über elektrische Leitungen verbunden, so dass eine Reihenschaltung von Batteriezellen 1 entsteht. Die so gebildete Batterieanlage dient allgemein als Notstromversorgung für eine Großanlage wie ein Krankenhaus oder eine Großrechneranlage einer Bank oder Versicherung.

Wie aus Figur 1 ersichtlich, weist die Batteriezelle 1, vorzugsweise jede Batteriezelle 1 der Batterieanlage, eine Aufnahme in Form eines Schlitzes 4 auf, der an der Oberseite der Batteriezelle 1 ausmündet. Der Schlitz 4 weist einen rechteckigen Querschnitt auf, der über eine gesamte Höhe konstant ist. Der Schlitz 4 wird seitlich von zwei Wandsegmenten 3a und unten von einem Boden 3b begrenzt, die Bestandteil des Gehäuses 3 der Batteriezelle 1 sind.

Von jedem Pol 2 der Batteriezelle 1 führt jeweils eine elektrische Zuleitung 5 zu einem elektrischen Kontakt 6 in dem die Aufnahme begrenzenden Wandsegment 3a. Die Kontakte 6 bilden zusätzlich zu den Polen 2 elektrische Anschlussmittel der Batteriezelle 1.

Figur 2 zeigt in einer Einzeldarstellung ein Testmodul 7, das dazu ausgebildet ist, Betriebsdaten einer Batteriezelle 1 zu deren Funktionsüberprüfung zu erfassen. Das Testmodul 7 enthält hierzu geeignete Sensormittel und eine Rechnereinheit zum Erfassen und Speichern von Betriebsdaten. Vorzugweise wird mit einem Testmodul 7 die Batteriespannung der Batteriezelle 1 und/oder deren Temperatur erfasst. Der untere Teil des Testmoduls 7 ist in Form eines Schafts 7a ausgebildet, dessen Kontur an die Form des Schlitzes 4 der Batteriezelle 1 angepasst ist. An gegenüberliegenden Seiten des Schafts 7a befinden sich elektrische Kontaktelemente 8, die korrespondierend zu den Kontakten 6 am Schlitz 4 der Batteriezelle 1 ausgebildet sind.

An der Oberseite des Testmoduls 7 befindet sich ein Schnittstellenelement 9, mittels dessen eine Datenübertragung mit externen Einheiten erfolgen kann. Diese Datenübertragung kann prinzipiell leitungsgebunden erfolgen. Im vorliegenden Fall erfolgt die Datenübertragung drahtlos. Das Schnittstellenelement 9 besteht dabei aus einem USB-Stecker, der in das Testmodul 7 einsteckbar ist. Der USB-Stecker enthält eine Adresse, unter welcher dieser innerhalb eines Netzwerks angesprochen werden kann. Durch das Einstecken des USB-Steckers in das Testmodul 7 ist dieses unter dieser Adresse innerhalb des Netzwerks adressierbar.

Zur Durchführung einer Funktionsprüfung der Batterieanlage wird in jeden Schlitz 4 einer Batteriezelle 1 ein Testmodul 7 eingesteckt. Da die Kontur des Schafts 7a des Testmoduls 7 an die Form des Schlitzes 4 angepasst ist, liegt der Schaft 7a des Testmoduls 7 formschlüssig im Schlitz 4 und bildet mit diesem eine Steckverbindung. Generell ist auch die Ausbildung einer Rastverbindung möglich.

Nach Einführen des Testmoduls 7 in den Schlitz 4 liegt der Schaft 7a in einer Sollposition, in welcher dessen Kontaktelemente 8 an den Kontakten 6 der Aufnahme anliegen und mit diesen eine leitende Verbindung bilden (Figur 3). Damit ist das Testmodul 7 elektrisch an die Batteriezelle 1 angeschlossen, ohne dass hierzu Anschlussmittel an den Polen 2 der Batteriezelle 1 angebracht werden müssen. Der elektrische Anschluss eines Testmoduls 7 an die Batteriezelle 1 erfolgt daher, ohne dass der Betrieb der Batteriezelle 1 unterbrochen werden müsste. Das Testmodul 7 ist dabei sofort betriebsbereit und kann Betriebsdaten der zugeordneten Batteriezelle 1 erfassen.

Vorzugsweise ist das Schnittstellenelement 9 des Testmoduls 7 galvanisch entkoppelt von der Batteriespannung der zugeordneten Batteriezelle 1. Die galvanische Entkopplung erfolgt vorteilhaft mittels eines im Testmodul 7 integrierten Schaltwandlers. Damit durch die galvanische Entkopplung nicht die Information über die Betriebsdaten verloren geht, moduliert der Schaltwandler die Batteriespannung, wobei in der Modulation die Information über die Betriebsdaten enthalten ist.

Über die Schnittstellenelemente 9 der Testmodule 7 werden die Betriebsdaten drahtlos an eine zentrale Erfassungsstelle gesendet. Die Erfassungsstelle kann von einem Personalcomputer oder dergleichen gebildet sein. Diese Erfassungsstelle ist zweckmäßig vor Ort an der Batterieanlage. Von dort werden die Betriebsdaten zum Hersteller der Batterieanlage gesendet, so dass die in der Erfassungsstelle ausgewerteten Betriebsdaten für die einzelnen Batteriezellen 1 vom Hersteller der Batterieanlage selbst beurteilt werden können. Der Hersteller beurteilt dann die Resultate der Funktionsprüfung dahingehend, ob ein kritischer Zustand der Batterieanlage vorliegt, welche ein Stillsetzen der Batterieanlage erfordert. Diese Beurteilung sendet der Hersteller der Batterieanlage an den Betreiber der Batterieanlage, so dass dieser entsprechende Maßnahmen ergreifen kann. Im Ergebnis übernimmt somit der Hersteller die Verantwortung, ob eine Batterieanlage stillgesetzt werden muss oder nicht.

### Bezugszeichenliste

- (1): Batteriezelle
- (2): Pole
- (3): Gehäuse
- (3a): Wandsegment
- (3b): Boden
- (4): Schlitz
- (5): Zuleitung
- (6): Kontakt
- (7): Testmodul
- (7a): Schaft
- (8): Kontaktelement
- (9): Schnittstellenelement

## Patentansprüche

1. Vorrichtung zur Überwachung von Betriebsdaten einer Batterieanlage bestehend aus einer Anordnung von miteinander verschalteten Batteriezellen (1), **dadurch gekennzeichnet, dass** zumindest ein Teil der Batteriezellen (1) eine Aufnahme aufweist, auf welche ein elektrischer Anschluss der Batteriezelle (1) geführt ist, und dass an den Aufnahmen ein Testmodul (7) anbringbar ist, wobei durch das Anbringen das Testmodul (7) elektrisch an die Batteriezelle (1) angeschlossen wird ohne den Betrieb der Batteriezelle (1) zu unterbrechen, und wobei mit dem Testmodul (7) Betriebsdaten erfassbar sind.

2. Vorrichtung nach Anspruch 1, **dadurch gekennzeichnet, dass** die Aufnahme in Form eines Schlitzes (4) ausgebildet ist.

3. Vorrichtung nach Anspruch 2, **dadurch gekennzeichnet, dass** die Kontur des Testmoduls (7) an die Form des Schlitzes (4) angepasst ist.

4. Vorrichtung nach einem der Ansprüche 1 bis 3, **dadurch gekennzeichnet, dass** das Testmodul (7) in die Aufnahme einsteckbar oder einrastbar ist.

5. Vorrichtung nach Anspruch 4, **dadurch gekennzeichnet, dass** durch Ausbildung der Steck- oder Rastverbindung das Testmodul (7) mit der Batteriezelle (1) elektrisch kontaktiert ist.

6. Vorrichtung nach einem der Ansprüche 1 bis 5, **dadurch gekennzeichnet, dass** jede Batteriezelle (1) eine Aufnahme aufweist, wobei die Aufnahmen identisch ausgebildet sind.

7. Vorrichtung nach einem der Ansprüche 1 bis 6, **dadurch gekennzeichnet, dass** die Aufnahme mit dem Testmodul (7) integraler Bestandteil einer Batteriezelle (1) sind.

8. Verfahren zur Überwachung von Betriebsdaten einer Batterieanlage bestehend aus einer Anordnung von miteinander verschalteten Batteriezellen (1), **dadurch gekennzeichnet, dass** zumindest an einem Teil der Batteriezellen (1) jeweils ein Testmodul (7) angeschlossen wird, um mit dem Testmodul (7) Betriebsdaten der Batteriezelle (1) zu erfassen, und dass die von den Testmodulen (7) erfassten Betriebsdaten an eine vom Betreiber der Batterieanlage unabhängige zentrale Erfassungsstelle gesendet werden, wo eine Bewertung der Betriebsdaten erfolgt.

9. Verfahren nach Anspruch 7, **dadurch gekennzeichnet, dass** die Erfassungsstelle vom Hersteller der Batterieanlage betrieben wird.

10. Verfahren nach einem der Ansprüche 8 oder 9, **dadurch gekennzeichnet, dass** das Ergebnis der Bewertung der Betriebsdaten von der Erfassungsstelle an den Betreiber der Betriebsanlage gesendet wird.

11. Verfahren nach einem der Ansprüche 7 bis 9, **dadurch gekennzeichnet, dass** die Betriebsdaten von den Testmodulen (7) drahtlos an die Erfassungsstelle gesendet werden.
